# EUROPEAN PATENT APPLICATION

(11) **EP 4 629 289 A1**
(43) Date of publication of application: **08.10.2025**
(21) Application number: 22967099.7
(22) Date of filing: 29.11.2022
(51) Int. Cl.: H01L 23/532, H01L 21/312

(54) **SEMICONDUCTOR DEVICE**

(71) Applicant: Nisshinbo Micro Devices Inc., Tokyo 103-8456 (JP); DIAMOND&ZEBRA ELECTRIC MFG. CO., LTD., Osaka 532-0026 (JP); Logic Research Co. Ltd., Fukuoka-shi, Fukuoka 814-0001 (JP)
(72) Inventor: HIGUCHI, Tetsuo, Fukuoka-Shi, Fukuoka 819-0161 (JP); TAKAYAMA, Kenji, Fukuoka-Shi, Fukuoka 819-0161 (JP); KOBAYASHI, Tomohiro, Fukuoka-Shi, Fukuoka 819-0161 (JP); YOSHIDA, Masataka, Fukuoka-Shi, Fukuoka 819-0161 (JP); MOTONAMI, Kaoru, Osaka-Shi, Osaka 532-0026 (JP); ISHIDA, Tomohiro, Osaka-Shi, Osaka 532-0026 (JP); WAKASUGI, Katsuhiko, Fukuoka-Shi, Fukuoka 814-0001 (JP)
(74) Representative: TBK
(86) International application number: PCT/JP2022/043901
(87) International publication number: WO 2024/116264

(57) **Abstract**

There is provided a semiconductor device including a substrate, an inorganic interlayer insulating film, an organic interlayer insulating film, a first conductive pattern, and a semiconductor nitride film. The inorganic interlayer insulating film is stacked above the substrate. The organic interlayer insulating film is stacked above the inorganic interlayer insulating film. The first conductive pattern is disposed in the inorganic interlayer insulating film. The first conductive pattern has a first conductivity. The second conductive pattern is disposed in the organic interlayer insulating film. The second conductive pattern has a second conductivity. The second conductivity is higher than the first conductivity. The semiconductor nitride film is disposed between the first conductive pattern and the organic interlayer insulating film in a stacking direction. The semiconductor nitride film contains hydrogen.

## Description

### TECHNICAL FIELD

The present embodiment relates to a semiconductor device.

### BACKGROUND ART

In a process of manufacturing a semiconductor device, multiple films are sequentially deposited on a substrate. The deposited films are patterned as needed.

### CITATION LIST

### Nonpatent Literature

Nonpatent Literature 1: IEEJ Journal, Vol.128, No.3, 2008
Nonpatent Literature 2: Polymer 55, February (2006)

### SUMMARY OF INVENTION

### PROBLEMS TO BE SOLVED BY THE INVENTION

The film may be patterned by dry etching accompanied by plasma irradiation. When dry etching is performed, a surface of the substrate irradiated with plasma may be damaged by the plasma. The plasma damage can be reduced by heat-treating the substrate at a relatively high temperature while supplying hydrogen.

However, in a case where a semiconductor device includes a structure in which an inorganic interlayer insulating film and an organic interlayer insulating film are stacked, the organic interlayer insulating film has a relatively low heat resistance, and it is difficult to heat-treat the organic interlayer insulating film at a relatively high temperature. As a result, when the plasma damage on the surface of the substrate is left unattended, there is a possibility that the characteristics of the semiconductor device deteriorate, for example, charges are more likely to be trapped in a channel region of a transistor.

An object of the present invention is to provide a semiconductor device capable of improving characteristics.

### MEANS FOR SOLVING PROBLEM

In order to solve the above problem and achieve the object, there is provided a semiconductor device including a substrate, an inorganic interlayer insulating film, an organic interlayer insulating film, a first conductive pattern, and a semiconductor nitride film. The inorganic interlayer insulating film is stacked above the substrate. The organic interlayer insulating film is stacked above the inorganic interlayer insulating film. The first conductive pattern is disposed in the inorganic interlayer insulating film. The first conductive pattern has a first conductivity. The second conductive pattern is disposed in the organic interlayer insulating film. The second conductive pattern has a second conductivity. The second conductivity is higher than the first conductivity. The semiconductor nitride film is disposed between the first conductive pattern and the organic interlayer insulating film in a stacking direction. The semiconductor nitride film contains hydrogen.

### BRIEF DESCRIPTION OF DRAWINGS

FIG. 1 is a cross-sectional view illustrating a schematic configuration of a semiconductor device according to an embodiment;
FIG. 2 is a plan view illustrating a schematic configuration of the semiconductor device according to the embodiment;
FIG. 3 is a cross-sectional view illustrating a detailed configuration of the semiconductor device according to the embodiment;
FIG. 4 is a diagram illustrating a characteristic of a transistor according to the embodiment;
FIG. 5A is a cross-sectional view illustrating a method for manufacturing the semiconductor device according to the embodiment;
FIG. 5B is a cross-sectional view illustrating the method for manufacturing the semiconductor device according to the embodiment;
FIG. 5C is a cross-sectional view illustrating the method for manufacturing the semiconductor device according to the embodiment;
FIG. 5D is a cross-sectional view illustrating the method for manufacturing the semiconductor device according to the embodiment;
FIG. 5E is a cross-sectional view illustrating the method for manufacturing the semiconductor device according to the embodiment;
FIG. 6A is a cross-sectional view illustrating the method for manufacturing the semiconductor device according to the embodiment;
FIG. 6B is a cross-sectional view illustrating the method for manufacturing the semiconductor device according to the embodiment;
FIG. 6C is a cross-sectional view illustrating the method for manufacturing the semiconductor device according to the embodiment;
FIG. 6D is a cross-sectional view illustrating the method for manufacturing the semiconductor device according to the embodiment;
FIG. 7A is a cross-sectional view illustrating the method for manufacturing the semiconductor device according to the embodiment;
FIG. 7B is a cross-sectional view illustrating the method for manufacturing the semiconductor device according to the embodiment;
FIG. 7C is a cross-sectional view illustrating the method for manufacturing the semiconductor device according to the embodiment;
FIG. 8 is a cross-sectional view illustrating a detailed configuration of a semiconductor device according to a modification of the embodiment;
FIG. 9A is a cross-sectional view illustrating a method for manufacturing the semiconductor device according to the modification of the embodiment;
FIG. 9B is a cross-sectional view illustrating the method for manufacturing the semiconductor device according to the modification of the embodiment;
FIG. 9C is a cross-sectional view illustrating the method for manufacturing the semiconductor device according to the modification of the embodiment;
FIG. 10A is a cross-sectional view illustrating the method for manufacturing the semiconductor device according to the modification of the embodiment;
FIG. 10B is a cross-sectional view illustrating the method for manufacturing the semiconductor device according to the modification of the embodiment; and
FIG. 10C is a cross-sectional view illustrating the method for manufacturing the semiconductor device according to the modification of the embodiment.

### DESCRIPTION OF EMBODIMENTS

Hereinafter, a semiconductor device according to an embodiment will be described in detail with reference to the accompanying drawings. Note that the present invention is not limited by this embodiment.

### (Embodiment)

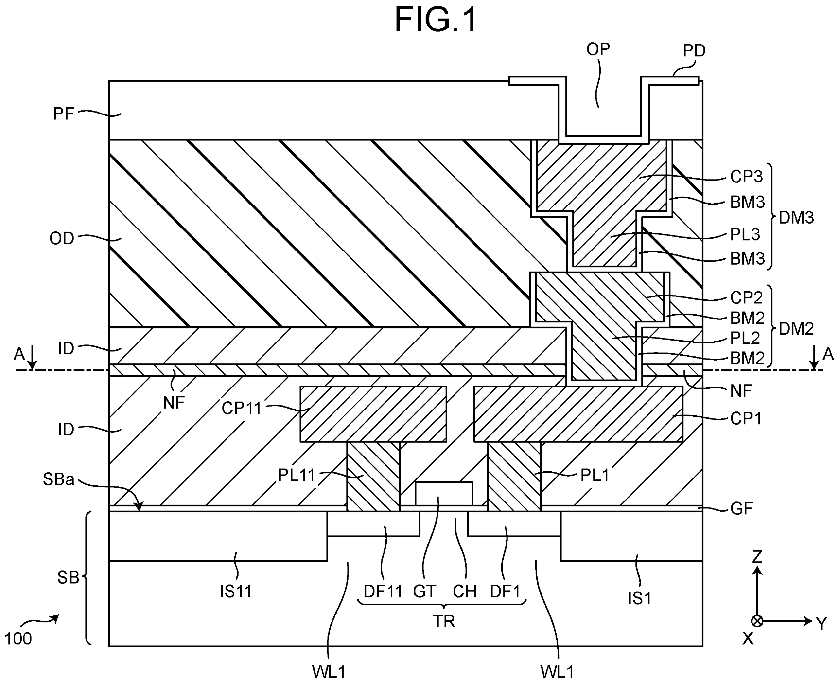

The semiconductor device according to the embodiment has a structure in which an inorganic interlayer insulating film and an organic interlayer insulating film are stacked, but is designed to reduce plasma damage to a substrate surface. For example, a semiconductor device 100 may be configured as illustrated in FIG. 1. Hereinafter, a direction perpendicular to a surface SBa of a substrate is defined as a Z direction, and two directions perpendicular to each other in a plane perpendicular to the Z direction are defined as an X direction and a Y direction. FIG. 1 is a YZ cross-sectional view illustrating a schematic configuration of the semiconductor device 100.

The semiconductor device 100 includes a substrate SB, an inorganic interlayer insulating film ID, an organic interlayer insulating film OD, conductive patterns CP1 and CP11, conductive plugs PL1 and PL11, a gate insulating film GF, a gate electrode film GT, a conductive pattern CP2, a conductive plug PL2, a seed film BM2, a conductive pattern CP3, a conductive plug PL3, a seed film BM3, a protective film PF, and an electrode film PD.

In the semiconductor device 100, the inorganic interlayer insulating film ID, the organic interlayer insulating film OD, and the protective film PF are sequentially stacked on the substrate SB. The inorganic interlayer insulating film ID is formed of an inorganic insulator having an insulating property, such as a silicon oxide. The organic interlayer insulating film OD is formed of an organic insulator having an insulating property.

Note that the organic interlayer insulating film OD may be formed of an organic insulator having a photosensitive property such as a photosensitive polymer. As a result, a wiring structure such as a damascene structure can be formed on the organic interlayer insulating film OD without forming a resist pattern, and a configuration suitable for simplifying the manufacturing process can be provided.

The substrate SB is a substantially plate-shaped member. The substrate SB includes a well region WL1, a semiconductor region DF1, a semiconductor region DF11, an element isolation portion IS1, and an element isolation portion IS11.

Each of the element isolation portion IS1 and the element isolation portion IS11 is disposed in the vicinity of the surface of the substrate SB. The element isolation portion IS1 and the element isolation portion IS11 are disposed at XY positions around the well region WL1, and the semiconductor region DF1 and the semiconductor region DF11, respectively. Each of the element isolation portion IS1 and the element isolation portion IS11 may be formed of an insulator such as a silicon oxide. The element isolation portion IS1 and the element isolation portion IS11 electrically isolate the well region WL1, and the semiconductor region DF1 and the semiconductor region DF11, respectively, from surrounding semiconductor regions.

The well region WL1 is disposed in the substrate SB to cover the semiconductor region DF1 and the semiconductor region DF11 from the -Z side, and is disposed in the vicinity of the surface of the substrate SB at an XY position between the semiconductor region DF1 and the semiconductor region DF11. A portion between the semiconductor region DF1 and the semiconductor region DF11 in the well region WL1 may be referred to as a channel region CH. The well region WL1 includes an impurity of first conductivity type at a first concentration.

Each of the semiconductor region DF1 and the semiconductor region DF11 is disposed in the vicinity of the surface of the substrate SB. Each of the semiconductor region DF1 and the semiconductor region DF11 is disposed at an XY position adjacent to the gate electrode film GT. The semiconductor region DF1 is disposed at a position adjacent to the gate electrode film GT when seen through in the Z direction. The semiconductor region DF11 is disposed at a position adjacent to the gate electrode film GT on the opposite side of the semiconductor region DF1 when seen through in the Z direction.

Each of the semiconductor region DF1 and the semiconductor region DF11 contains an impurity of second conductivity type at a second concentration higher than the first concentration. The second conductivity type is a conductivity type opposite to the first conductivity type. Each of the semiconductor region DF1 and the semiconductor region DF11 is also referred to as a diffusion layer.

For example, when the first conductivity type is P-type, the impurity of the first conductivity type may be boron. The second conductivity type may be N-type, and the impurity of the second conductivity type may be phosphorus or arsenic.

When the first conductivity type is N-type, the impurity of the first conductivity type may be phosphorus or arsenic. The second conductivity type may be P-type, and the impurity of the second conductivity type may be boron.

The gate insulating film GF extends to cover the surface of the substrate SB. The gate insulating film GF partially exposes the surface of the semiconductor region DF1 and partially exposes the surface of the semiconductor region DF11. The gate insulating film GF may be formed of an insulator such as a silicon oxide.

The gate electrode film GT is disposed on the gate insulating film GF. The gate electrode film GT is disposed at a planar position between the semiconductor region DF1 and the semiconductor region DF11. The gate electrode film GT may be formed of a semiconductor to which conductivity is imparted or a conductor such as a metal.

The conductive patterns CP1 and CP11 are disposed in the inorganic interlayer insulating film ID. The conductive patterns CP1 and CP11 have a conductivity σ1. The conductive patterns CP1 and CP11 are disposed above the substrate SB. Each of the conductive patterns CP1 and CP11 may be formed of a conductor containing a metal such as aluminum as a main component. The conductive patterns CP1 and CP11 are connected to the semiconductor regions DF1 and DF11 via the conductive plugs PL1 and PL11.

The conductive plug PL1 is disposed in the inorganic interlayer insulating film ID. The conductive plug PL1 extends in the Z direction to electrically connect the conductive pattern CP1 and the semiconductor region DF1. A +Z side end of the conductive plug PL1 is connected to a -Z side surface of the conductive pattern CP1, the conductive plug PL1 extends in the Z direction and penetrates the gate insulating film GF, and a -Z side end of the conductive plug PL1 is connected to the semiconductor region DF1. The conductive plug PL1 may be made of a material containing a metal such as tungsten as a main component.

The conductive plug PL11 is disposed in the inorganic interlayer insulating film ID. The conductive plug PL11 extends in the Z direction to electrically connect the conductive pattern CP11 and the semiconductor region DF11. A +Z side end of the conductive plug PL11 is connected to a -Z side surface of the conductive pattern CP11, the conductive plug PL11 extends in the Z direction and penetrates the gate insulating film GF, and a -Z side end of the conductive plug PL11 is connected to the semiconductor region DF11. The conductive plug PL11 may be made of a material containing a metal such as tungsten as a main component.

The conductive pattern CP2 is disposed in the organic interlayer insulating film OD. The conductive pattern CP2 has a conductivity σ2. The conductivity σ2 is higher than the conductivity σ1. The conductive pattern CP2 is disposed above the conductive patterns CP1 and CP11. The conductive pattern CP2 may be formed of a conductor containing a metal such as copper as a main component. The conductive pattern CP2 is connected to the conductive pattern CP1 via the conductive plug PL2 and the seed film BM2.

The conductive plug PL2 is disposed in the inorganic interlayer insulating film ID. The conductive plug PL2 extends in the Z direction to electrically connect the conductive pattern CP2 and the conductive pattern CP1. A +Z side end of the conductive plug PL2 is connected to a -Z side surface of the conductive pattern CP2, the conductive plug PL2 extends in the Z direction, and a -Z side end of the conductive plug PL2 is connected to the conductive pattern CP1 via the seed film BM2. The conductive plug PL2 may be formed of the same material as the conductive pattern CP2, or may be formed of a conductor containing a metal such as copper as a main component.

The seed film BM2 is disposed across the inorganic interlayer insulating film ID and the organic interlayer insulating film OD. The seed film BM2 covers a lateral surface and a -Z side surface of the conductive plug PL2, and covers a lateral surface and a -Z side surface of the conductive pattern CP2. The seed film BM2 may be formed of a material having a barrier property against the material of the conductive pattern CP2 and the material of the conductive plug PL2. The seed film BM2 may be made of a material having a barrier property such as titanium, tantalum, titanium nitride, or tantalum nitride.

The conductive pattern CP3 is disposed in the organic interlayer insulating film OD. The conductive pattern CP3 has a conductivity σ2. The conductivity σ2 is higher than the conductivity σ1. The conductive pattern CP3 is disposed on a +Z side of the conductive pattern CP2. The conductive pattern CP3 may be formed of a conductor containing a metal such as copper as a main component. The conductive pattern CP3 is connected to the conductive pattern CP2 via the conductive plug PL3 and the seed film BM3.

The conductive plug PL3 is disposed in the organic interlayer insulating film OD. The conductive plug PL3 extends in the Z direction to electrically connect the conductive pattern CP3 and the conductive pattern CP2. A +Z side end of the conductive plug PL3 is connected to a -Z side surface of the conductive pattern CP3, the conductive plug PL3 extends in the Z direction, and a -Z side end of the conductive plug PL3 is connected to the conductive pattern CP2 via the seed film BM3. The conductive plug PL3 may be formed of the same material as the conductive pattern CP3, or may be formed of a conductor containing a metal such as copper as a main component.

The seed film BM3 is disposed in the organic interlayer insulating film OD. The seed film BM3 covers a lateral surface and a -Z side surface of the conductive plug PL3, and covers a lateral surface and a -Z side surface of the conductive pattern CP3. The seed film BM3 may be formed of a material having a barrier property against the material of the conductive pattern CP3 and the material of the conductive plug PL3. The seed film BM3 may be made of a material having a barrier property such as titanium, tantalum, titanium nitride, or tantalum nitride.

The protective film PF is disposed on a +Z side of the organic interlayer insulating film OD. The protective film PF covers the organic interlayer insulating film OD. The protective film PF may be formed of an insulator such as a semiconductor nitride (e.g., a silicon nitride). The protective film PF has an opening pattern OP that exposes a +Z side surface of the conductive pattern CP3 at an XY position corresponding to the conductive pattern CP3.

The electrode film PD selectively covers a lateral surface and a bottom surface of the opening pattern OP. The electrode film PD covers the +Z side surface of the conductive pattern CP3. As a result, the electrode film PD is connected to the conductive pattern CP3.

In the semiconductor device 100, a configuration including the semiconductor region DF1, the semiconductor region DF11, the gate electrode film GT, and the channel region CH functions as a transistor TR. The semiconductor region DF1 functions as a source or a drain of the transistor TR. The semiconductor region DF11 functions as a drain or a source of the transistor TR. The gate electrode film GT functions as a gate of the transistor TR. The conductive patterns CP1 and CP11 form a first wiring layer. The conductive plugs PL1 and PL11 function as wiring for connection between the first layer wiring and the transistor TR. The conductive pattern CP2 forms a second wiring layer. The conductive pattern CP2, the conductive plug PL2, and the seed film BM2 constitute a dual damascene structure DM2, and function as wiring for connection between the second layer wiring and the first layer wiring. The conductive pattern CP3 forms a third wiring layer. The conductive pattern CP3, the conductive plug PL3, and the seed film BM3 constitute a dual damascene structure DM3, and function as wiring for connection between the third layer wiring and the second layer wiring.

Here, the surface of the substrate SB may be damaged by plasma during the manufacturing process, and may have, for example, dangling bonds. The plasma damage can be reduced, for example, by heat-treating the substrate surface at a relatively high temperature (e.g., about 400°C) while supplying hydrogen to terminate dangling bonds on the surface of the substrate SB with the hydrogen.

However, the semiconductor device 100 has a structure in which the inorganic interlayer insulating film ID and the organic interlayer insulating film OD are stacked. The organic interlayer insulating film OD has a relatively low heat resistance, and it is difficult to heat-treat the organic interlayer insulating film OD at a relatively high temperature. As a result, when the plasma damage on the surface of the substrate SB is left unattended, there is a possibility that the characteristics of the semiconductor device 100 deteriorate, for example, charges are more likely to be trapped in the channel region CH of the transistor TR.

In the conductive pattern CP2 and the conductive plug PL2, the element of the conductor (e.g., a metal containing copper as a main component) may be diffused to the surroundings, as the diffusion of the element of the conductor is not completely suppressed by the seed film BM2. When the element of the conductor is diffused to the gate insulating film GF, there is a possibility that characteristics of the semiconductor device 100 deteriorate, such as an occurrence of an insulation failure in the gate insulating film GF of the transistor TR.

Therefore, in the present embodiment, as illustrated in FIG. 1, the semiconductor device 100 further includes a semiconductor nitride film NF containing hydrogen. The semiconductor nitride film NF is disposed between the conductive patterns CP1 and CP11 and the organic interlayer insulating film OD in the Z direction (stacking direction).

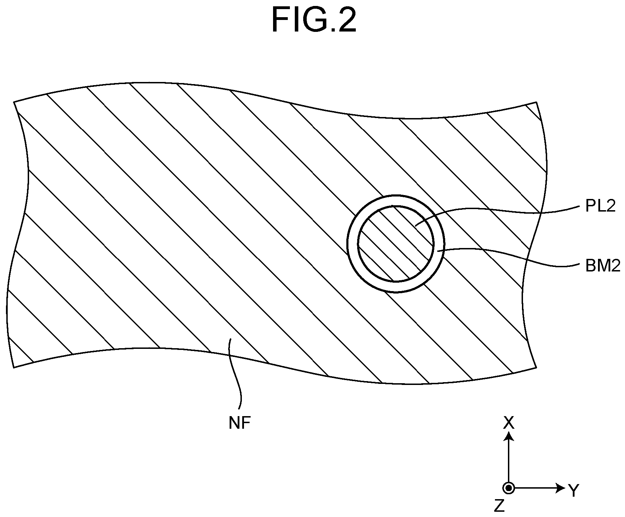

As illustrated in FIGS. 1 and 2, the semiconductor nitride film NF is disposed at least at an XY position (planar position) corresponding to the gate electrode film GT. FIG. 2 is a plan view illustrating a schematic configuration of the semiconductor device 100, and is an XY plan view illustrating a configuration of the semiconductor device 100 when viewed from above after being cut along line A-A of FIG. 1. The semiconductor nitride film NF may be disposed to cover the channel region CH when seen through in a direction perpendicular to the substrate SB. The conductive plug PL2 and the seed film BM2 penetrate the semiconductor nitride film NF, and lateral surfaces of the conductive plug PL2 and the seed film BM2 are covered with the semiconductor nitride film NF over their entire perimeters. The semiconductor nitride film NF may be formed of a silicon nitride containing hydrogen.

As a result, hydrogen can be diffused from the semiconductor nitride film NF and supplied to the surface of the substrate SB (e.g., the surface of the channel region CH), and the dangling bonds on the surface of the substrate SB can be terminated with the hydrogen without performing heat treatment at a relatively high temperature. As a result, plasma damage to the channel region CH of the transistor TR can be reduced, and the characteristics of the semiconductor device 100 can be improved.

In addition, the semiconductor nitride film NF can be formed without any gap in the vicinity of the conductive plug PL2 and the seed film BM2, making it possible to reliably block the element of the conductor diffused from the conductive plug PL2 and the seed film BM2 to the surroundings. As a result, an insulation failure in the gate insulating film GF of the transistor TR can be suppressed, and the characteristics of the semiconductor device 100 can be improved.

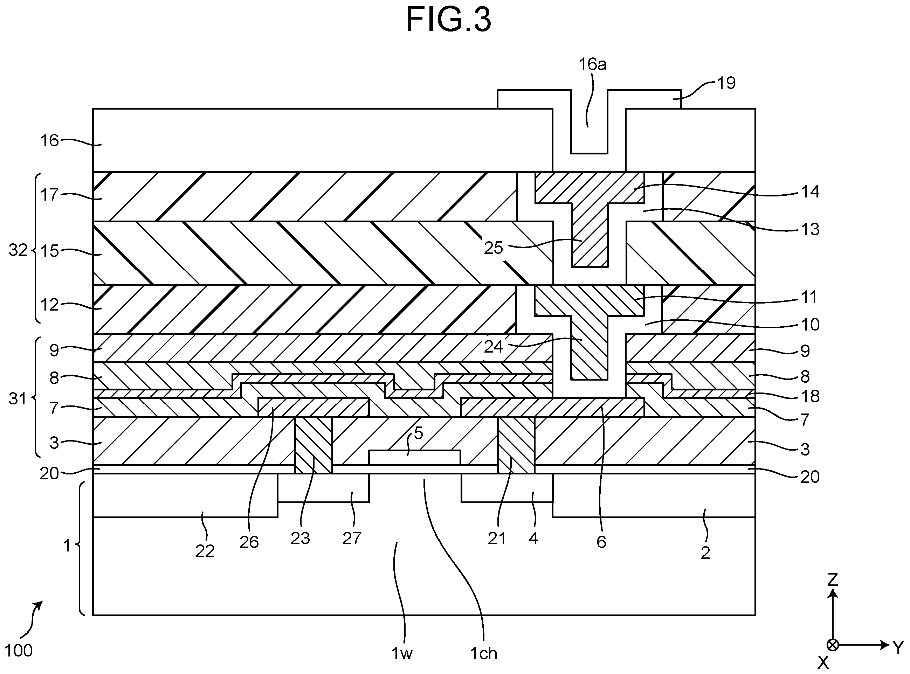

Specifically, in the semiconductor device 100, the semiconductor nitride film may be disposed at a position between multiple insulating films included in the inorganic interlayer insulating film as illustrated in FIG. 3. FIG. 3 is a cross-sectional view illustrating a detailed configuration of the semiconductor device 100.

The semiconductor device 100 illustrated in FIG. 3 includes a substrate 1, an inorganic insulating film 3, an inorganic insulating film 7, an inorganic insulating film 8, an inorganic insulating film 9, an organic insulating film 12, an organic insulating film 15, an organic insulating film 17, conductive patterns 6 and 26, conductive plugs 21 and 23, a gate insulating film 20, a gate electrode film 5, a conductive pattern 11, a conductive plug 24, a seed film 10, a conductive pattern 14, a conductive plug 25, a seed film 13, a protective film 16, an electrode film 19, and a semiconductor nitride film 18.

FIG. 3 exemplifies a detailed configuration corresponding to the schematic configuration illustrated in FIG. 1. The substrate 1 corresponds to the substrate SB. The inorganic interlayer insulating film 31 corresponds to the inorganic interlayer insulating film ID. The organic interlayer insulating film 32 corresponds to the organic interlayer insulating film OD. The conductive patterns 6 and 26 correspond to the conductive patterns CP1 and CP11. The conductive plugs 21 and 23 correspond to the conductive plugs PL1 and PL11. The gate insulating film 20 corresponds to the gate insulating film GF. The gate electrode film 5 corresponds to the gate electrode film GT. The conductive pattern 11 corresponds to the conductive pattern CP2. The conductive plug 24 corresponds to the conductive plug PL2. The seed film 10 corresponds to the seed film BM2. The conductive pattern 14 corresponds to the conductive pattern CP3. The conductive plug 25 corresponds to the conductive plug PL3. The seed film 13 corresponds to the seed film BM3. The protective film 16 corresponds to the protective film PF. The opening pattern 16a corresponds to the opening pattern OP. The electrode film 19 corresponds to the electrode film PD. The semiconductor nitride film 18 corresponds to the semiconductor nitride film NF.

The substrate 1 includes a well region 1w, a semiconductor region 4, a semiconductor region 27, an element isolation portion 2, and an element isolation portion 22. The well region 1w corresponds to the well region WL1. The semiconductor region 4 corresponds to the semiconductor region DF1. The semiconductor region 27 corresponds to the semiconductor region DF11. The element isolation portion 2 corresponds to the element isolation portion IS1. The element isolation portion 22 corresponds to the element isolation portion IS11.

The organic interlayer insulating film 32 has a structure in which multiple organic insulating films 12, 15, and 17 are stacked.

The inorganic interlayer insulating film 31 has a structure in which multiple inorganic insulating films 3, 7, 8, and 9 are stacked.

The semiconductor nitride film 18 is disposed between the multiple inorganic insulating films 3, 7, 8, and 9 included in the inorganic interlayer insulating film 31. The semiconductor nitride film 18 may be disposed between the inorganic insulating film 7 and the inorganic insulating film 8.

Specifically, the inorganic insulating film 3 covers the gate insulating film 20 and the gate electrode film 5. The conductive plugs 21 and 23 penetrate the inorganic insulating film 3 at XY positions corresponding to the semiconductor regions 4 and 27. The conductive pattern 6 covers the conductive plug 21 and a portion on a +Z side surface of the inorganic insulating film 3 around the conductive plug 21. The conductive pattern 26 covers the conductive plug 23 and a portion on the +Z side surface of the inorganic insulating film 3 around the conductive plug 23.

The inorganic insulating film 7 covers the inorganic insulating film 3 and the conductive patterns 6 and 26. The inorganic insulating film 7 may have a film thickness of 200 nm to 350 nm. The inorganic insulating film 7 has a step corresponding to a difference between the +Z side surface of the inorganic insulating film 3 and +Z side surfaces of the conductive patterns 6 and 26. The inorganic insulating film 7 is penetrated by the conductive plug 24 and the seed film 10 at an XY position corresponding to the conductive pattern 6.

The semiconductor nitride film 18 covers the inorganic insulating film 7. The semiconductor nitride film 18 may have a film thickness of 100 nm to 200 nm. The semiconductor nitride film 18 has a step corresponding to the step of the inorganic insulating film 7. The semiconductor nitride film 18 is penetrated by the conductive plug 24 and the seed film 10 at an XY position corresponding to the conductive pattern 6.

The inorganic insulating film 8 covers the semiconductor nitride film 18. The inorganic insulating film 8 may have a film thickness of 200 nm to 250 nm. The -Z side surface of the inorganic insulating film 8 has a step corresponding to the step of the semiconductor nitride film 18, and the +Z side surface of the inorganic insulating film 8 is flat. The inorganic insulating film 8 is penetrated by the conductive plug 24 and the seed film 10 at an XY position corresponding to the conductive pattern 6.

The inorganic insulating film 9 covers the inorganic insulating film 8. The inorganic insulating film 9 is flat. The inorganic insulating film 9 may have a film thickness of 400 nm to 500 nm. The inorganic insulating film 9 is penetrated by the conductive plug 24 and the seed film 10 at an XY position corresponding to the conductive pattern 6.

The multiple insulating films (the organic insulating film 12, the organic insulating film 15, and the organic insulating film 17) of the organic interlayer insulating film 32 are disposed on a +Z side of the inorganic interlayer insulating film 31.

The organic insulating film 12 covers the inorganic insulating film 9. The organic insulating film 12 is flat. The organic insulating film 12 is penetrated by the conductive pattern 11 and the seed film 10 at an XY position corresponding to the conductive pattern 6.

The organic insulating film 15 covers the organic insulating film 12. The organic insulating film 15 is flat. The organic insulating film 15 is penetrated by the conductive plug 25 and the seed film 13 at an XY position corresponding to the conductive pattern 6.

The organic insulating film 17 covers the organic insulating film 15. The organic insulating film 17 is flat. The organic insulating film 17 is penetrated by the conductive pattern 14 and the seed film 13 at an XY position corresponding to the conductive pattern 6.

According to the configuration illustrated in FIG. 3, as mentioned before, hydrogen can be diffused from the semiconductor nitride film 18 and supplied to the surface of the substrate 1 (e.g., the surface of the channel region 1ch), and the dangling bonds in the vicinity of the surface of the substrate 1 can be terminated with the hydrogen without performing heat treatment at a relatively high temperature. In addition, the semiconductor nitride film 18 can be formed without any gap in the vicinity of the conductive plug 24 and the seed film 10, making it possible to reliably block the element of the conductor diffused from the conductive plug 24 and the seed film 10 toward the surroundings. As a result, the characteristics of the transistor including the gate electrode film 5, the semiconductor region 4, the semiconductor region 27, and the channel region 1ch can be improved.

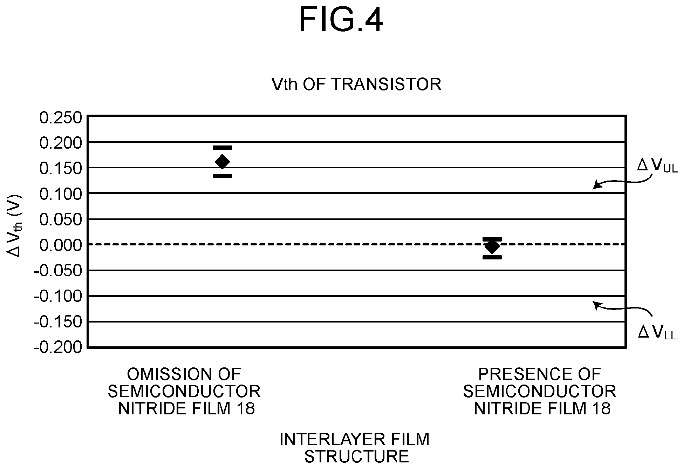

For example, in a case where each of the semiconductor region 4 and the semiconductor region 27 is an N-type semiconductor region and the transistor is an NMOS transistor, prototypes were created and evaluated for a configuration in which the semiconductor nitride film 18 was omitted from the configuration illustrated in FIG. 3 (the configuration with "omission of the semiconductor nitride film 18") and a configuration in which the semiconductor nitride film 18 illustrated in FIG. 3 was provided (the configuration with "presence of the semiconductor nitride film 18"). In the evaluation, for each configuration, a threshold voltage of the NMOS transistor was measured, and a difference from the target value was obtained as a threshold variation amount ΔVth. For each configuration, an average value, a maximum value, and a minimum value of threshold variation amounts ΔVth in multiple prototypes were obtained and plotted. FIG. 4 is a diagram illustrating a characteristic of the transistor, and exemplifies variations in threshold characteristic in the configuration with "omission of the semiconductor nitride film 18" and the configuration with "presence of the semiconductor nitride film 18". In FIG. 4, the average value is indicated by a black square, and the maximum value and the minimum value are indicated by error bars for each of the configuration with "omission of the semiconductor nitride film 18" and the configuration with "presence of the semiconductor nitride film 18".

As illustrated by the plot on the left side in FIG. 4, in the configuration with "omission of the semiconductor nitride film 18", the threshold variation amount ΔVth tends to deviate from an allowable range. The allowable range is a range between an allowable upper limit value ΔV_{UL} and an allowable lower limit value ΔV_{LL}. The allowable upper limit value ΔV_{UL} is, for example, 0.1 V, and the allowable lower limit value ΔV_{LL} is, for example, - 0.1 V. In addition, as indicated by the error bars on the left side in FIG. 4, in the configuration with "omission of the semiconductor nitride film 18", the variations between the multiple prototypes tend to be large.

As indicated by the plot on the right side in FIG. 4, in the configuration with "presence of the semiconductor nitride film 18", the threshold variation amount ΔVth tends to fall within the allowable range. In addition, as indicated by the error bars on the right side in FIG. 4, in the configuration with "presence of the semiconductor nitride film 18", the variations between the multiple prototypes tend to be small.

That is, it has been confirmed that, by disposing the semiconductor nitride film 18 between the conductive patterns 6 and 26 and the organic interlayer insulating film 32 in the Z direction (stacking direction), the threshold voltage of the transistor including the gate electrode film 5, the semiconductor region 4, the semiconductor region 27, and the channel region 1ch can be kept within the allowable range, and the variation in threshold can also be reduced. That is, it has been confirmed that the characteristics of the transistor can be improved.

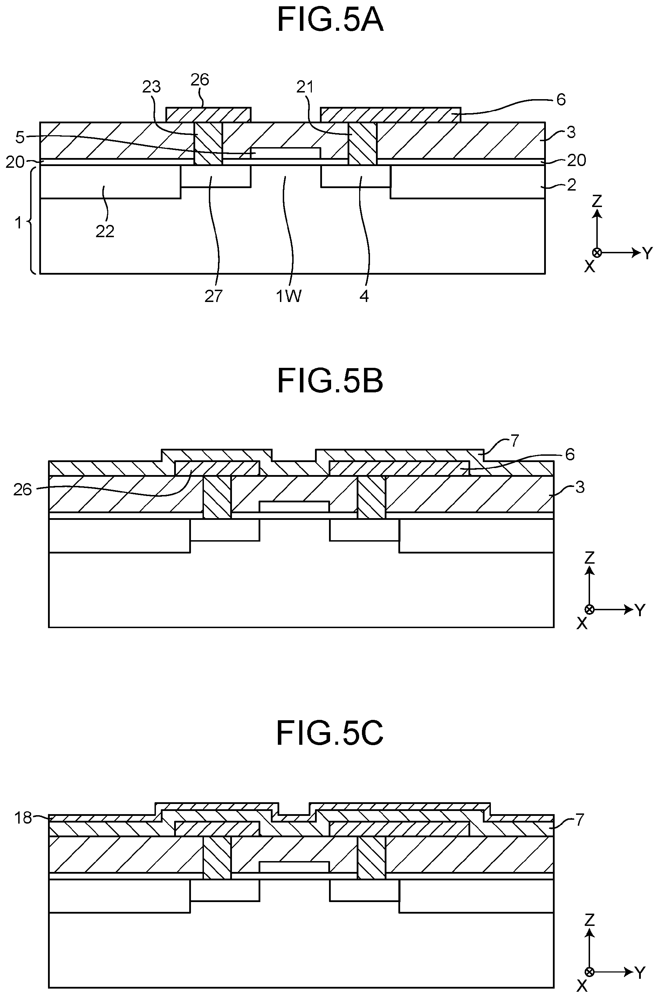

Next, a method for manufacturing the semiconductor device 100 will be described with reference to FIGS. 5A to 5E, FIGS. 6A to 6D, FIGS. 7A to 7C, and FIG. 3. FIGS. 5A to 5E, FIGS. 6A to 6D, and FIGS. 7A to 7C are cross-sectional views illustrating a method for manufacturing the semiconductor device 100. FIG. 3 is a cross-sectional view illustrating a configuration of the semiconductor device 100, but is used as a cross-sectional view illustrating a manufacturing method. FIGS. 5A to 7C and FIG. 3 exemplify a flow of manufacturing a multilayer wiring structure in which an interlayer insulating film is formed by stacking an inorganic interlayer insulating film and an organic interlayer insulating film, and a dual damascene process is adopted after two-layer wiring (after the organic interlayer insulating film).

In a step illustrated in FIG. 5A, the element isolation portion 2 and the element isolation portion 22 are formed in the vicinity of the surface in the substrate 1. The substrate 1 may be formed of a semiconductor such as silicon containing an impurity of first conductivity type at a first concentration. The element isolation portion 2 and the element isolation portion 22 may be formed of an insulator such as a silicon oxide. The gate insulating film 20 is formed on the surface of the substrate 1. The gate insulating film 20 may be made of an insulator such as a silicon oxide. A conductive film is formed on the gate insulating film 20, a resist pattern RP1 selectively covering an XY position corresponding to the gate electrode film 5 is formed, and dry etching using plasma is performed using the resist pattern RP1 as a mask. As a result, the conductive film is patterned so that the gate electrode film 5 is formed. The gate electrode film 5 may be formed of a semiconductor (e.g., polysilicon) to which conductivity is imparted. The resist pattern RP1 is removed by oxygen plasma (plasma asher) processing. At this time, plasma damage may be formed in the vicinity of the surface of the substrate 1.

An impurity of second conductivity type is introduced in the vicinity of the surface of the well region 1w in the substrate 1 using the gate electrode film 5 as a mask by an ion implantation method or the like, so that the semiconductor regions 4 and 27 are formed. The semiconductor regions 4 and 27 contain the impurity of second conductivity type at a second concentration higher than the first concentration. The second conductivity type is a conductivity type opposite to the first conductivity type. At this time, damage may be formed in the vicinity of the surface of the substrate 1 due to ion implantation.

Thereafter, the substrate 1 is heat-treated at a relatively high temperature while supplying hydrogen. As a result, the plasma damage and the damage caused due to the ion implantation in the vicinity of the surface of the substrate 1 may be reduced.

The inorganic insulating film 3 is formed to cover the gate insulating film 20 and the gate electrode film 5. In the inorganic insulating film 3, contact holes extending in the Z direction and exposing partial portions of surfaces of the semiconductor regions 4 and 27 are formed. A conductor is embedded in the contact holes so that the conductive plugs 21 and 23 are formed. A conductive film is formed on the inorganic insulating film 3 and the conductive plugs 21 and 23, resist patterns RP2 selectively covering XY positions corresponding to the conductive plugs 21 and 23 are formed, and dry etching accompanied by plasma irradiation is performed using the resist patterns RP2 as masks. As a result, the conductive film is patterned so that the conductive patterns 6 and 26 are formed. The conductive patterns 6 and 26 may be formed of a conductor containing a metal such as aluminum as a main component. The resist patterns RP2 are removed by oxygen plasma (plasma asher) processing. At this time, plasma damage may be formed on the surface of the substrate 1.

In a step illustrated in FIG. 5B, the inorganic insulating film 7 is deposited to cover the inorganic insulating film 3 and the conductive patterns 6 and 26 by a plasma CVD method or the like. The inorganic insulating film 7 may be formed to have a film thickness of 200 nm to 350 nm. The inorganic insulating film 7 may be formed of an inorganic insulator such as a silicon oxide.

In a step illustrated in FIG. 5C, the semiconductor nitride film 18 is deposited to cover the inorganic insulating film 7 by a plasma CVD method using a silane (SiH₄) gas or the like. The semiconductor nitride film 18 may be formed to have a film thickness of 100 nm to 200 nm. The semiconductor nitride film 18 may be formed of an inorganic insulator such as a silicon nitride containing hydrogen. For example, the plasma CVD process is performed while supplying a silane (SiH₄) gas and an ammonia (NH₃) gas into the chamber. The semiconductor nitride film 18 is deposited to cover the inorganic insulating film 7. The hydrogen content of the semiconductor nitride film 18 may be adjusted by changing the flow ratio between the silane gas and the ammonia gas during the plasma CVD process.

Here, in the configuration illustrated in FIG. 5C, when hydrogen contained in the semiconductor nitride film 18 is diffused to the surface of the substrate 1, dangling bonds on the surface of the substrate SB can be terminated with the hydrogen, and plasma damage can be reduced in the vicinity of the surface of the substrate 1.

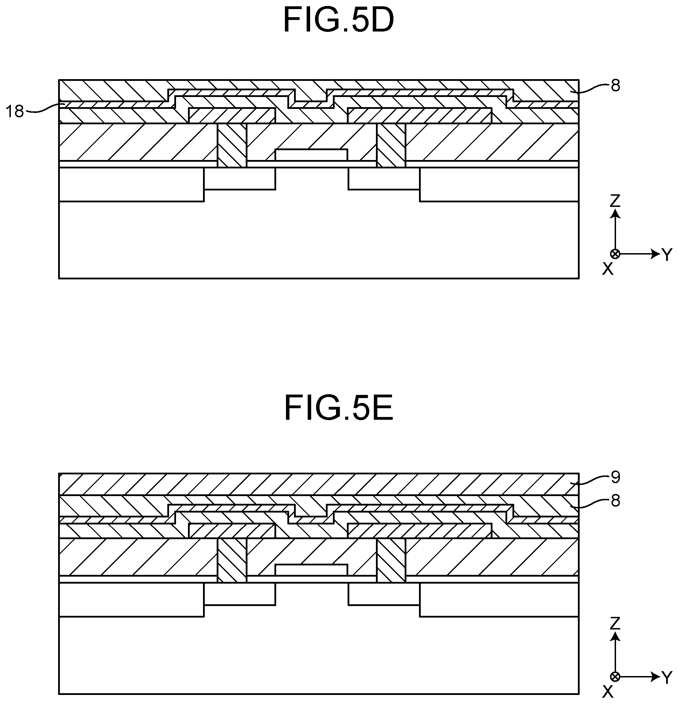

In a step illustrated in FIG. 5D, a chemical solution containing an inorganic insulator such as a silicon oxide is applied onto a +Z side of the semiconductor nitride film 18 by a spin coating method or the like, and the chemical solution is dried, so that the inorganic insulating film 8 is formed to cover the semiconductor nitride film 18. The inorganic insulating film 8 may be formed to have a film thickness of 200 nm to 250 nm. The inorganic insulating film 8 is also called a spin on glass (SOG) film. The inorganic insulating film 8 has a flat surface on the +Z side, and functions as a flattening film.

In a step illustrated in FIG. 5E, the inorganic insulating film 9 is deposited to cover the inorganic insulating film 8 by a plasma CVD method or the like. The inorganic insulating film 9 may be formed to have a film thickness of 400 nm to 500 nm. The inorganic insulating film 9 may be formed of an inorganic insulator such as a silicon oxide.

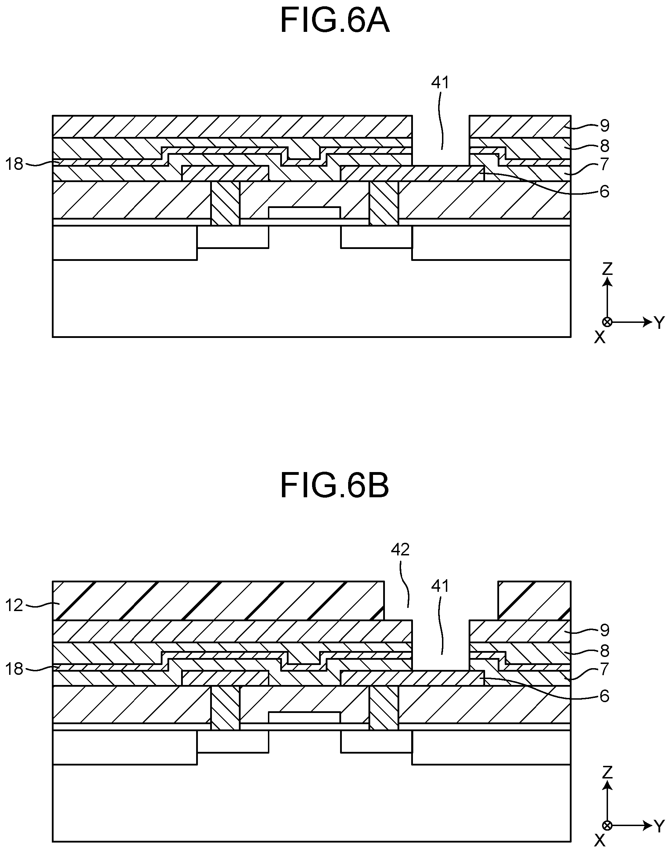

In a step illustrated in FIG. 6A, a resist pattern RP3 covering a +Z side surface of the inorganic insulating film 9 is formed in a region where a via hole 41 is to be formed to have an opening. Dry etching accompanied by plasma irradiation is performed under the condition of high anisotropy using the resist pattern RP3 as a mask. As a result, the via hole 41 penetrating the inorganic insulating film 9, the inorganic insulating film 8, the semiconductor nitride film 18, and the inorganic insulating film 7 and exposing a +Z side surface of the conductive pattern 6 is formed. The resist pattern RP3 is removed by oxygen plasma (plasma asher) processing. At this time, plasma damage may be formed on a +Z side surface of the substrate 1.

Here, in the configuration illustrated in FIG. 6A, when hydrogen contained in the semiconductor nitride film 18 is diffused to the surface of the substrate 1, dangling bonds in the vicinity of the surface of the substrate SB can be terminated with the hydrogen, and plasma damage can be reduced in the vicinity of the surface of the substrate 1.

In a step illustrated in FIG. 6B, a chemical solution containing an organic insulator such as a photosensitive polymer is applied onto a +Z side of the inorganic insulating film 9 by a spin coating method or the like. In a case where the organic insulator is a negative photosensitive polymer, a region other than the region where the opening pattern 42 is to be formed in the chemical solution is exposed. In a case where the organic insulator is a positive photosensitive polymer, the region where the opening pattern 42 is to be formed in the chemical solution is exposed. The chemical solution is developed and dried, so that the organic insulating film 12 having the opening pattern 42 at an XY position corresponding to the via hole 41 is formed. The opening pattern 42 may be formed such that the via hole 41 is included inside the opening pattern 42 when seen through in the Z direction. The opening pattern 42 may be formed, for example, up to 1.5 µm outside the via hole 41 when seen through in the Z direction.

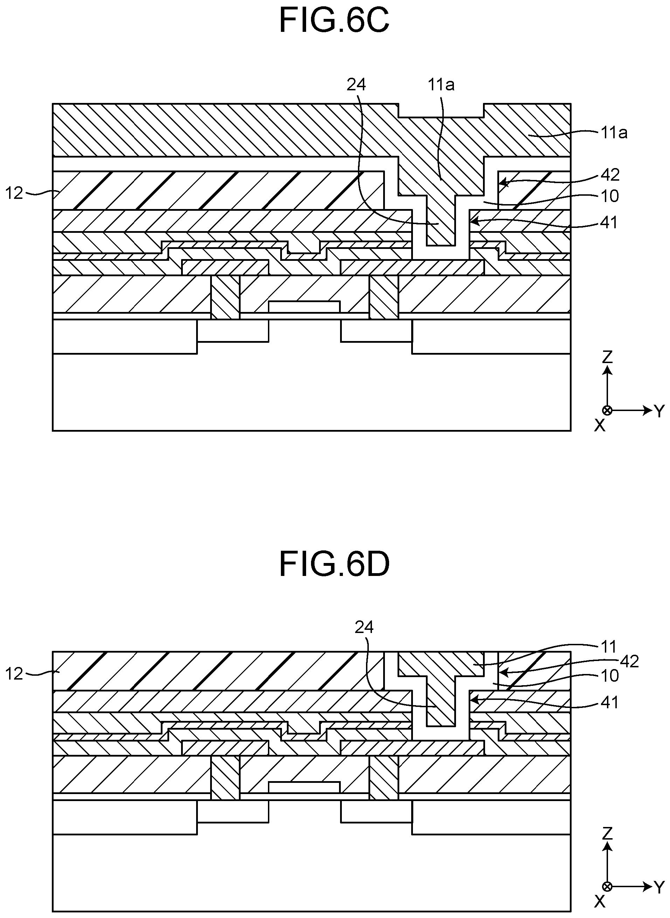

In a step illustrated in FIG. 6C, the seed film 10 is deposited over an entire surface by a plasma CVD method or the like. The seed film 10 may be formed to have a film thickness of 150 nm to 200 nm. The seed film 10 is made of a material (e.g., titanium, tantalum, titanium nitride, tantalum nitride, or the like) having a barrier property against the conductor that is to be the conductive pattern 11 and the conductive plug 24. As a result, the seed film 10 covering a lateral surface and a bottom surface of the opening pattern 42 and a lateral surface and a bottom surface of the via hole 41 is formed.

A conductive material 11a is formed to have a predetermined thickness (e.g., 1.5 µm to 2.0 µm) over an entire surface by a plating method or the like. As a result, the conductive material 11a is embedded in the opening pattern 42 and the via hole 41. The conductive material 11a may be formed of a conductor containing a metal such as copper as a main component. The conductive plug 24 in the via hole 41 and the conductive pattern 11 in the opening pattern 42 are formed together.

In a step illustrated in FIG. 6D, polishing is performed by a CMP method or the like until a +Z side surface of the organic insulating film 12 is exposed. As a result, the conductive material 11a and the seed film 10 on a +Z side of the organic insulating film 12 are removed, the seed film 10 and the conductive plug 24 are left in the via hole 41, and the seed film 10 and the conductive pattern 11 are left in the opening pattern 42.

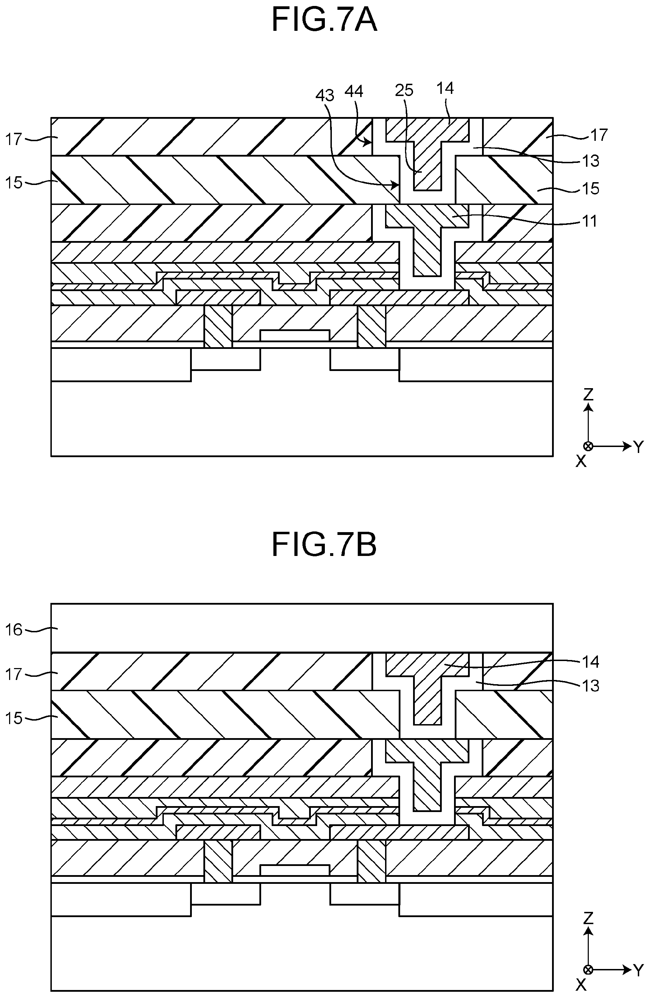

In a step illustrated in FIG. 7A, a chemical solution containing an organic insulator such as a photosensitive polymer is applied onto the +Z side of the organic insulating film 12 by a spin coating method or the like. In a case where the organic insulator is a negative photosensitive polymer, a region other than the region where a via hole 43 is to be formed in the chemical solution is exposed. In a case where the organic insulator is a positive photosensitive polymer, the region where the via hole 43 is to be formed in the chemical solution is exposed. The chemical solution is developed and dried, so that the organic insulating film 15 having the via hole 43 at an XY position corresponding to the conductive pattern 11 is formed. The via hole 43 may be formed to expose a +Z side surface of the conductive pattern 11.

A chemical solution containing an organic insulator such as a photosensitive polymer is applied onto the +Z side of the organic insulating film 15 by a spin coating method or the like. In a case where the organic insulator is a negative photosensitive polymer, a region other than the region where an opening pattern 44 is to be formed in the chemical solution is exposed. In a case where the organic insulator is a positive photosensitive polymer, the region where the opening pattern 44 is to be formed in the chemical solution is exposed. The chemical solution is developed and dried, so that the organic insulating film 17 having the opening pattern 44 at an XY position corresponding to the via hole 43 is formed. The opening pattern 44 may be formed such that the via hole 43 is included inside the opening pattern 44 when seen through in the Z direction. The opening pattern 44 may be formed, for example, up to 1.5 µm outside the via hole 43 when seen through in the Z direction.

The seed film 13 is deposited over an entire surface by a plasma CVD method or the like. The seed film 13 may be formed to have a film thickness of 150 nm to 200 nm. The seed film 13 is made of a material (e.g., titanium, tantalum, titanium nitride, tantalum nitride, or the like) having a barrier property against the conductor that is to be the conductive pattern 14 and the conductive plug 25. As a result, the seed film 13 covering a lateral surface and a bottom surface of the opening pattern 44 and a lateral surface and a bottom surface of the via hole 43 is formed.

A conductive material 14a is formed to have a predetermined thickness (e.g., 1.5 µm to 2.0 µm) over an entire surface by a plating method or the like. As a result, the conductive material 14a is embedded in the opening pattern 44 and the via hole 43. The conductive material 14a may be formed of a conductor containing a metal such as copper as a main component. The conductive plug 25 in the via hole 43 and the conductive pattern 14 in the opening pattern 44 are formed together.

Polishing is performed by a CMP method or the like until a +Z side surface of the organic insulating film 17 is exposed. As a result, the conductive material 14a and the seed film 13 on the +Z side of the organic insulating film 17 are removed, the seed film 13 and the conductive plug 25 are left in the via hole 43, and the seed film 13 and the conductive pattern 14 are left in the opening pattern 44.

In a step illustrated in FIG. 7B, the protective film 16 is deposited on the +Z side of the organic insulating film 17 by a plasma CVD method or the like. The protective film 16 may be formed of an insulator such as a semiconductor nitride (e.g., a silicon nitride). The protective film 16 may be formed to have a thickness (e.g., 750 nm) required to protect the semiconductor device 100.

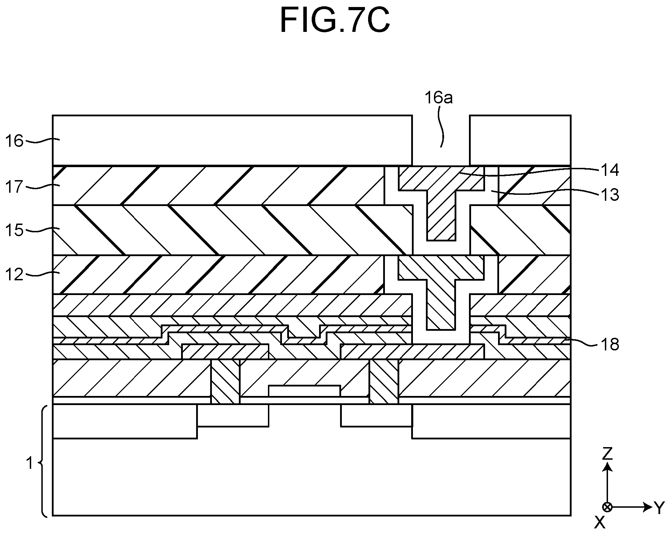

In a step illustrated in FIG. 7C, a resist pattern RP4 is formed covering a +Z side surface of protective film 16 is formed in a region where opening pattern 16a is to be formed to have an opening. Dry etching accompanied by plasma irradiation is performed under the condition of high anisotropy using the resist pattern RP4 as a mask. As a result, the opening pattern 16a penetrating the protective film 16 and exposing a +Z side surface of the conductive pattern 14 is formed. The resist pattern RP4 is removed by oxygen plasma (plasma asher) processing. At this time, plasma damage may be formed on a +Z side surface of the substrate 1.

Here, in a case where each of the organic insulating film 12, the organic insulating film 15, and the organic insulating film 17 is formed of an organic insulator, it is difficult to perform heat treatment at a high temperature exceeding a heat resistance temperature of the organic insulator, and it is difficult to perform heat treatment at a relatively high temperature for reducing plasma damage.

In contrast, in the configuration illustrated in FIG. 7C, when hydrogen contained in the semiconductor nitride film 18 is diffused to the surface of the substrate 1, dangling bonds in the vicinity of the surface of the substrate 1 can be terminated with the hydrogen, and plasma damage can be reduced in the vicinity of the surface of the substrate 1.

In the configuration illustrated in FIG. 3, a conductive film 19a is deposited over an entire surface by a sputtering method or the like. The conductive film 19a is deposited on a bottom surface and a lateral surface of the opening pattern 16a. The conductive film 19a may be formed of a conductor containing a metal such as aluminum as a main component. A resist pattern RP5 selectively covering the vicinity of a via hole 46 is formed on a +Z side surface of the conductive film 19a. Dry etching accompanied by plasma irradiation is performed under the condition of high anisotropy using the resist pattern RP5 as a mask. As a result, the electrode film 19 covering the bottom surface and the lateral surface of the opening pattern 16a is formed. The resist pattern RP5 is removed by oxygen plasma (plasma asher) processing. As a result, the semiconductor device 100 is obtained. At this time, plasma damage may be formed on a +Z side surface of the substrate 1.

Here, in a case where each of the organic insulating film 12, the organic insulating film 15, and the organic insulating film 17 is formed of an organic insulator, it is difficult to perform heat treatment at a high temperature exceeding a heat resistance temperature of the organic insulator, and it is difficult to perform heat treatment at a relatively high temperature for reducing plasma damage.

In contrast, in the configuration illustrated in FIG. 3, when hydrogen contained in the semiconductor nitride film 18 is diffused to the surface of the substrate 1, dangling bonds in the vicinity of the surface of the substrate 1 can be terminated with the hydrogen, and plasma damage can be reduced in the vicinity of the surface of the substrate 1.

As described above, in the semiconductor device 100 according to the embodiment, the semiconductor nitride film NF containing hydrogen is disposed between the first layer wiring (the conductive patterns CP1 and CP11) and the organic interlayer insulating film OD in the Z direction (see FIG. 1). For example, the semiconductor nitride film 18 is disposed between the multiple inorganic insulating films 3, 7, 8, and 9 included in the inorganic interlayer insulating film 31 (see FIG. 3). The semiconductor nitride film 18 may be disposed between the inorganic insulating film 7 and the inorganic insulating film 8. As a result, hydrogen can be diffused from the semiconductor nitride film 18 and supplied to the surface of the substrate 1 (e.g., the surface of the channel region 1ch), and the dangling bonds in the vicinity of the surface of the substrate 1 can be terminated with the hydrogen without performing heat treatment at a relatively high temperature. In addition, the semiconductor nitride film 18 can be formed without any gap in the vicinity of the conductive plug 24 and the seed film 10 (see FIG. 2), making it possible to reliably block the element of the conductor (e.g., a copper element) diffused from the conductive plug 24 and the seed film 10 toward the surroundings. As a result, the characteristics of the transistor including the gate electrode film 5, the semiconductor region 4, the semiconductor region 27, and the channel region 1ch can be improved.

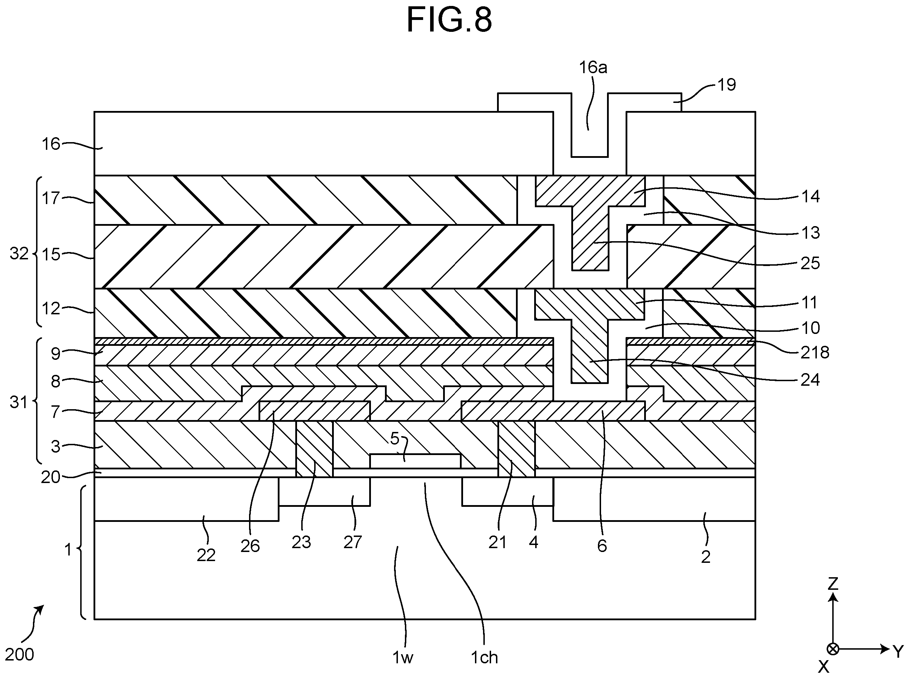

Note that the position at which a semiconductor nitride film 218 is disposed in a semiconductor device 200 may be an interface between the organic interlayer insulating film 32 and the inorganic interlayer insulating film 31 as illustrated in FIG. 8. FIG. 8 is a cross-sectional view illustrating a detailed configuration of a semiconductor device 200 according to a modification of the embodiment.

The inorganic insulating film 8 covers the inorganic insulating film 7. The inorganic insulating film 8 may have a film thickness of 200 nm to 250 nm. The -Z side surface of the inorganic insulating film 8 has a step corresponding to the step of the inorganic insulating film 7, and the +Z side surface of the inorganic insulating film 8 is flat. The inorganic insulating film 8 is penetrated by the conductive plug 24 and the seed film 10 at an XY position corresponding to the conductive pattern 6.

The semiconductor nitride film 218 is disposed at an interface between the organic interlayer insulating film 32 and the inorganic interlayer insulating film 31. The semiconductor nitride film 218 covers the inorganic insulating film 9 in the inorganic interlayer insulating film 31. The semiconductor nitride film 218 may have a film thickness of 100 nm to 200 nm. The semiconductor nitride film 218 is flat. The semiconductor nitride film 218 is penetrated by the conductive plug 24 and the seed film 10 at an XY position corresponding to the conductive pattern 6.

In the semiconductor device 200, hydrogen can be diffused from the semiconductor nitride film 218 and supplied to the surface of the substrate 1 (e.g., the surface of the channel region 1ch), and the dangling bonds on the surface of the substrate 1 can be terminated with the hydrogen without performing heat treatment at a relatively high temperature. In addition, the semiconductor nitride film 218 can be formed without any gap in the vicinity of the conductive plug 24 and the seed film 10, making it possible to reliably block the element of the conductor diffused from the conductive plug 24 and the seed film 10 to the surroundings. As a result, an insulation failure in the gate insulating film 20 of the transistor can be suppressed, and the characteristics of the semiconductor device 200 can be improved.

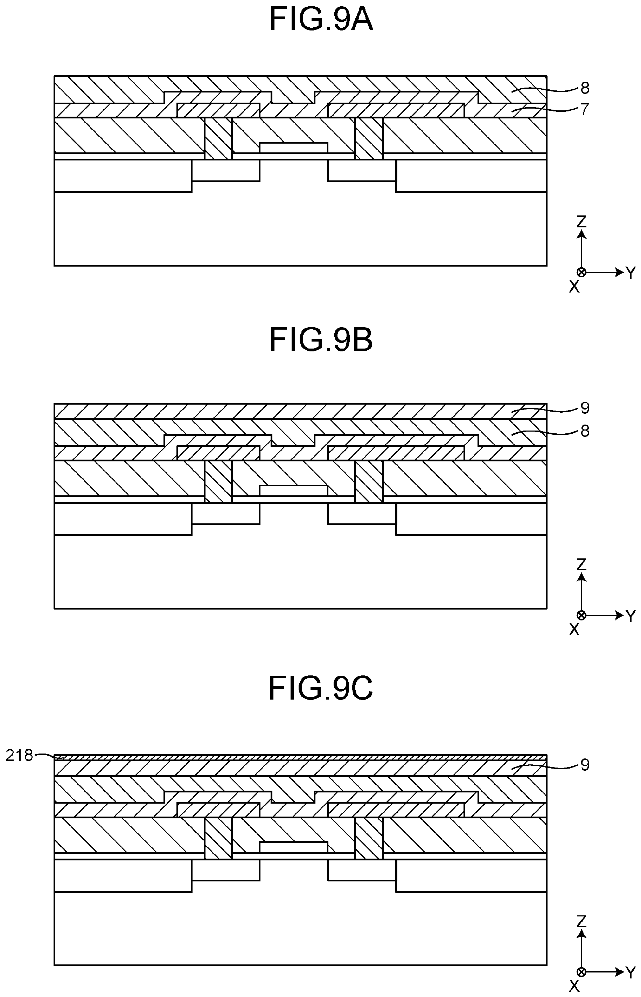

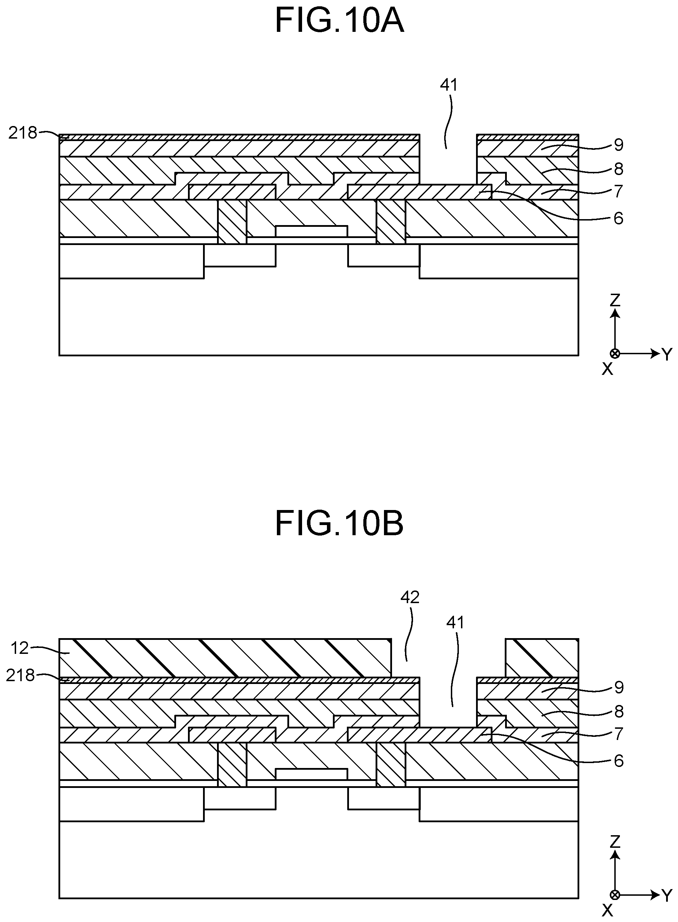

In addition, as illustrated in FIGS. 9A to 10C, a method for manufacturing the semiconductor device 200 is different from the embodiment in the following points. FIGS. 9A to 9C and FIGS. 10A to 10C are cross-sectional views illustrating a method for manufacturing the semiconductor device 200.

After steps similar to those in FIGS. 5A and 5B are performed, a step illustrated in FIG. 9A is performed. In the step illustrated in FIG. 9A, a chemical solution containing an inorganic insulator such as a silicon oxide is applied onto a +Z side of the inorganic insulating film 7 by a spin coating method or the like, and the chemical solution is dried, so that the inorganic insulating film 8 is formed to cover the inorganic insulating film 7. The inorganic insulating film 8 may be formed to have a film thickness of 200 nm to 250 nm. The inorganic insulating film 8 is also called a spin on glass (SOG) film. The inorganic insulating film 8 has a flat surface on the +Z side, and functions as a flattening film.

In a step illustrated in FIG. 9B, the inorganic insulating film 9 is deposited to cover the inorganic insulating film 8 by a plasma CVD method or the like. The inorganic insulating film 9 may be formed to have a film thickness of 400 nm to 500 nm. The inorganic insulating film 9 may be formed of an inorganic insulator such as a silicon oxide.

In a step illustrated in FIG. 9C, the semiconductor nitride film 218 is deposited to cover the inorganic insulating film 9 by a plasma CVD method using a silane (SiH₄) gas or the like. The semiconductor nitride film 218 may be formed to have a film thickness of 100 nm to 200 nm. The semiconductor nitride film 218 may be formed of an inorganic insulator such as a silicon nitride containing hydrogen. For example, the plasma CVD process is performed while supplying a silane (SiH₄) gas and an ammonia (NH₃) gas into the chamber. The semiconductor nitride film 218 is deposited to cover the inorganic insulating film 7. The hydrogen content of the semiconductor nitride film 218 may be adjusted by changing the flow ratio between the silane gas and the ammonia gas during the plasma CVD process.

In a step illustrated in FIG. 10A, a resist pattern RP3 covering a +Z side surface of the inorganic insulating film 9 is formed in a region where a via hole 41 is to be formed to have an opening. Dry etching accompanied by plasma irradiation is performed under the condition of high anisotropy using the resist pattern RP3 as a mask. As a result, the via hole 41 penetrating the semiconductor nitride film 218, the inorganic insulating film 9, the inorganic insulating film 8, and the inorganic insulating film 7 and exposing a +Z side surface of the conductive pattern 6 is formed. The resist pattern RP3 is removed by oxygen plasma (plasma asher) processing. At this time, plasma damage may be formed on a +Z side surface of the substrate 1.

Here, in the configuration illustrated in FIG. 10A, when hydrogen contained in the semiconductor nitride film 218 is diffused to the surface of the substrate 1, dangling bonds in the vicinity of the surface of the substrate SB can be terminated with the hydrogen, and plasma damage can be reduced in the vicinity of the surface of the substrate 1.

In a step illustrated in FIG. 10B, a chemical solution containing an organic insulator such as a photosensitive polymer is applied onto a +Z side of the semiconductor nitride film 218 by a spin coating method or the like. In a case where the organic insulator is a negative photosensitive polymer, a region other than the region where the opening pattern 42 is to be formed in the chemical solution is exposed. In a case where the organic insulator is a positive photosensitive polymer, the region where the opening pattern 42 is to be formed in the chemical solution is exposed. The chemical solution is developed and dried, so that the organic insulating film 12 having the opening pattern 42 at an XY position corresponding to the via hole 41 is formed. The opening pattern 42 may be formed such that the via hole 41 is included inside the opening pattern 42 when seen through in the Z direction. The opening pattern 42 may be formed, for example, up to 1.5 µm outside the via hole 41 when seen through in the Z direction.

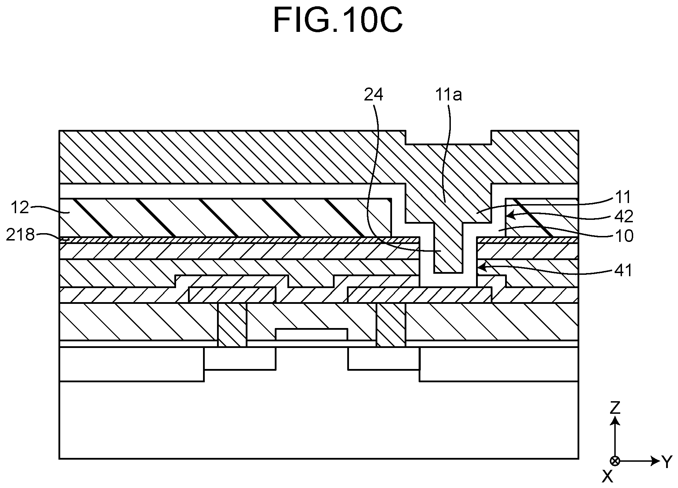

In a step illustrated in FIG. 10C, the seed film 10 is deposited over an entire surface by a plasma CVD method or the like. The seed film 10 may be formed to have a film thickness of 150 nm to 200 nm. The seed film 10 is made of a material (e.g., titanium, tantalum, titanium nitride, tantalum nitride, or the like) having a barrier property against the conductor that is to be the conductive pattern 11 and the conductive plug 24. As a result, the seed film 10 covering a lateral surface and a bottom surface of the opening pattern 42 and a lateral surface and a bottom surface of the via hole 41 is formed.

A conductive material 11a is formed to have a predetermined thickness (e.g., 1.5 µm to 2.0 µm) over an entire surface by a plating method or the like. As a result, the conductive material 11a is embedded in the opening pattern 42 and the via hole 41. The conductive material 11a may be formed of a conductor containing a metal such as copper as a main component. The conductive plug 24 in the via hole 41 and the conductive pattern 11 in the opening pattern 42 are formed together.

Thereafter, steps similar to those in FIGS. 6D, FIGS. 7A to 7C, and FIG. 3 are performed, so that the semiconductor device 200 illustrated in FIG. 8 is obtained.

In this way, in the semiconductor device 200, the semiconductor nitride film 218 is disposed at the interface between the inorganic interlayer insulating film 31 and the organic interlayer insulating film 32 (see FIG. 8). As a result, hydrogen can be diffused from the semiconductor nitride film 218 and supplied to the surface of the substrate 1 (e.g., the surface of the channel region 1ch), and the dangling bonds in the vicinity of the surface of the substrate 1 can be terminated with the hydrogen without performing heat treatment at a relatively high temperature. In addition, the semiconductor nitride film 218 can be formed without any gap in the vicinity of the conductive plug 24 and the seed film 10 (see FIG. 2), making it possible to reliably block the element of the conductor (e.g., a copper element) diffused from the conductive plug 24 and the seed film 10 to the surroundings. As a result, the characteristics of the transistor including the gate electrode film 5, the semiconductor region 4, the semiconductor region 27, and the channel region 1ch can be improved.

Although some embodiments of the present invention have been described, these embodiments have been presented as examples, and are not intended to limit the scope of the invention. These novel embodiments can be implemented in various other forms, and various omissions, substitutions, and changes can be made without departing from the gist of the invention. These embodiments and modifications thereof fall within the scope and gist of the invention, and fall within in the scope of the invention set forth in the claims and equivalents thereof.

### EXPLANATIONS OF LETTERS OR NUMERALS

1, SB SUBSTRATE
5, GT GATE ELECTRODE FILM
6, 26, CP1, CP11 CONDUCTIVE PATTERN
7 INORGANIC INSULATING FILM
8 INORGANIC INSULATING FILM
9 INORGANIC INSULATING FILM
11, CP2 CONDUCTIVE PATTERN
12 ORGANIC INSULATING FILM
14, CP3 CONDUCTIVE PATTERN
15 ORGANIC INSULATING FILM
17 ORGANIC INSULATING FILM
18, 218, NF SEMICONDUCTOR NITRIDE FILM
21, 23, PL1, PL11 CONDUCTIVE PLUG
24, PL2 CONDUCTIVE PLUG
25, PL3 CONDUCTIVE PLUG
31, ID INORGANIC INTERLAYER INSULATING FILM
32, OD ORGANIC INTERLAYER INSULATING FILM
100, 200 SEMICONDUCTOR DEVICE

## Claims

1. A semiconductor device comprising:
a substrate;
an inorganic interlayer insulating film stacked above the substrate;
an organic interlayer insulating film stacked above the inorganic interlayer insulating film;
a first conductive pattern disposed in the inorganic interlayer insulating film, the first conductive pattern having a first conductivity;
a second conductive pattern disposed in the organic interlayer insulating film, the second conductive pattern having a second conductivity, the second conductivity being higher than the first conductivity; and
a semiconductor nitride film disposed between the first conductive pattern and the organic interlayer insulating film in a stacking direction, the semiconductor nitride film containing hydrogen.

2. The semiconductor device according to claim **1,** further comprising:
a gate electrode film disposed on the substrate, wherein
the semiconductor nitride film is disposed at least at a planar position corresponding to the gate electrode film.

3. The semiconductor device according to claim 1, wherein
the semiconductor nitride film is disposed at an interface between the inorganic interlayer insulating film and the organic interlayer insulating film.

4. The semiconductor device according to claim 1, wherein
the inorganic interlayer insulating film includes multiple insulating films, and
the semiconductor nitride film is disposed between the multiple insulating films in the stacking direction.

5. The semiconductor device according to claim 4, wherein
the multiple insulating films includes:
a first insulating film covering the first conductive pattern;
a second insulating film stacked above the first insulating film; and
a third insulating film stacked above the second insulating film, and
the semiconductor nitride film is disposed at an interface between the first insulating film and the second insulating film.

6. The semiconductor device according to claim 1, wherein
the organic interlayer insulating film has photosensitivity.

7. The semiconductor device according to claim 1, further comprising:
a conductive plug extending from the second conductive pattern in the stacking direction, the conductive plug penetrating the semiconductor nitride film, and conductive plug reaching the first conductive pattern, wherein
the second conductive pattern and the conductive plug form a damascene structure.

8. The semiconductor device according to claim **1,** wherein
the first conductive pattern is formed of a material containing aluminum as a main component, and
the second conductive pattern is formed of a material containing copper as a main component.
